(19) **Europäisches Patentamt**

**European Patent Office**

**Office européen des brevets**

(11) **EP 1 089 430 A2**

(12) **EUROPEAN PATENT APPLICATION**

(43) Date of publication:
04.04.2001 Bulletin 2001/14

(51) Int. Cl.⁷: **H03G 7/00**

(21) Application number: **00115467.3**

(22) Date of filing: **18.07.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **30.09.1999 US 410489**

(71) Applicant:
**Agilent Technologies Inc.,
A Delaware Corporation
Palo Alto, CA 94306-2024 (US)**

(72) Inventor: **Kipnis, Issy
Berkeley, CA 94707 (US)**

(74) Representative:
**Schoppe, Fritz, Dipl.-Ing.
Schoppe, Zimmermann & Stöckeler
Patentanwälte
Postfach 71 08 67
81458 München (DE)**

(54) **A dB-linear variable gain amplifier**

(57) A dB-linear amplifier (Fig. 6) for producing a logarithmic variable gain response to a gain control (603), thereby developing an output signal (Ic,663) proportional to an input signal (Vb,621; Ic,625) by applying the input signal to an variable gain amplifier with a natural logarithmic variable gain response at a bias current (Ie,661; Ie,663), further scaling the response to a dB-linear value, and providing the output current (Ic,663) proportional to the input signal at a gain proportional to the dB-linear value of the gain control (603).

*Fig. 6*

**EP 1 089 430 A2**

## Description

Field of the Invention:

The invention relates to a dB-linear variable gain amplifier, and particularly to a temperature compensated dB-linear variable gain amplifier.

Background of the Invention:

Signals with a wide range of amplitudes, such as with audio amplification, often require amplifiers with a log-linear or compression-type response. For example, high quality audio may have a range of 64,000 to 1 or greater; representing 1 millivolt to 64 volts. Both values are outside the usable range of many amplifiers, since 1 millivolt will often be too noisy, and 64 volts is too much voltage. A compression amplifier, for the same range, would have a much smaller and therefore more manageable set of operating voltages. However, compression type amplifiers have a gain that varies with amplitude, and the output may contain substantial distortion products. Many applications are adversely affected by this distortion, which can be shown to be due to large amounts of harmonics introduced in the process of compressing the signal.

A dB-linear amplifier can achieve substantially the same result with much less harmonics by varying the gain as a function of an externally introduced control signal. However, forming a dB-linear amplifier requires that the compression products be separated from the linear signal being amplified. Attempts to solve this problem have been made many times. In one approach dB-linear amplifiers are realized with piece-wise-linear approximation techniques. The output of the amplifier is controlled by, for example, feed back that varies with operating point. As the control voltage increases the amplifier gain decreases with an approximate fit to a log-linear curve, e. g., an exponential or square law curve. This provides fairly good operation, but to prevent distortion many steps in the piecewise-linear approximation are required, and the complexity and cost of implementation becomes quite large. This is because the approach approximates a smooth exponential waveform with a series of straight lines, and to gain relative smoothness in the output of the amplifier there must be many small lines.

It is also known that a semiconductor diode exhibits a log-linear response (the natural log), but the range is set by the diode characteristics, which vary with temperature and have an offset that may be difficult to compensate for. Additionally, the same problem of simultaneously varying the gain and the amplitude of the input, forming cross products, still exists. Log-linear amplifiers built with this principle have been reported to be linear and well behaved over more than six decades of operating range, but they are difficult to use due to their characteristics. In fact, piece-wise linear amplifiers are often preferred to avoid the problems with diode log-linear amplifiers.

All semiconductors are temperature sensitive. A technique commonly used in band gap regulators and similar circuits allows the temperature sensitivity to be adjusted, but for the prior art dB-linear amplifiers, the adjustment is performed in a separate step or module, which can lead to multiplying errors between the modules. One approach is to make a temperature stable separate amplifier and apply it to a piece-wise linear amplifier. This further increases the cost and complexity of the amplifier.

There is a long-felt need for an inherently temperature compensated, simple dB-linear amplifier without the break points and consequent distortion found in piece-wise linear approximations.

Summary of the Invention:

A current is introduced through a resistor in series with a diode forward voltage, or Vt, and in parallel with a diode characteristic Vf. That is, the voltage drop across the resistor controls the change in the diode forward drop Vf from Vt to some relatively large forward voltage. The resulting current is exponential, as desired. The diode being controlled is part of a transistor to reduce loading effects on the resistor based control circuit.

If the bias current points, also called idling current, of the current through the resistor in series with the value Vt and the parallel device supplying Vf are adjusted appropriately, and/or the device sizes are appropriately adjusted, temperature sensitivity of the circuit can be compensated for predictably.

Other objects, features and advantages of the present invention will become apparent from the following detailed description when taken in conjunction with the accompanying drawings.

BRIEF DESCRIPTION OF THE DRAWINGS

The accompanying drawings, which are incorporated in and form a part of this specification, illustrate embodiments of the invention and, together with the description, serve to explain the principles of the invention:

Fig. 1 is a functional block diagram of a dB-linear response to a linear input.
Fig. 1A illustrates the relationship between an input current, and output from a compression amplifier, and an output from a dB-linear variable gain amplifier.
Fig. 2 is an input pair for a variable gain amplifier (VGA).
Fig. 3 is a functional block of a predistortion circuit for use with the invention.
Fig. 4 is a linear to dB-linear circuit in accordance with the invention.

Fig. 5 illustrates the makeup of the PTAT or proportional to absolute temperature circuit.

Fig. 6 is a complete circuit used in a commercial application.

Fig. 7 is a graph of the dB-linear response to a linear input as a function of temperature in the circuit of Fig. 6.

Fig. 8 is a graph of the linear response of the circuit of Fig. 6.

Fig. 9 is a graph of the response of a linear circuit without temperature compensation.

Fig. 10 is a graph of the response of a linear circuit with temperature compensation.

## DETAILED DESCRIPTION OF THE PREFERRED EMBODIMENTS

Reference will now be made in detail to the preferred embodiments of the invention, examples of which are illustrated in the accompanying drawings. While the invention will be described in conjunction with the preferred embodiments, it will be understood that they are not intended to limit the invention to those embodiments. On the contrary, the invention is intended to cover alternatives, modifications and equivalents, which may be included within the spirit and scope of the invention as defined by the appended claims.

A new approach to a dB-linear variable gain amplifier {VGA) is described.

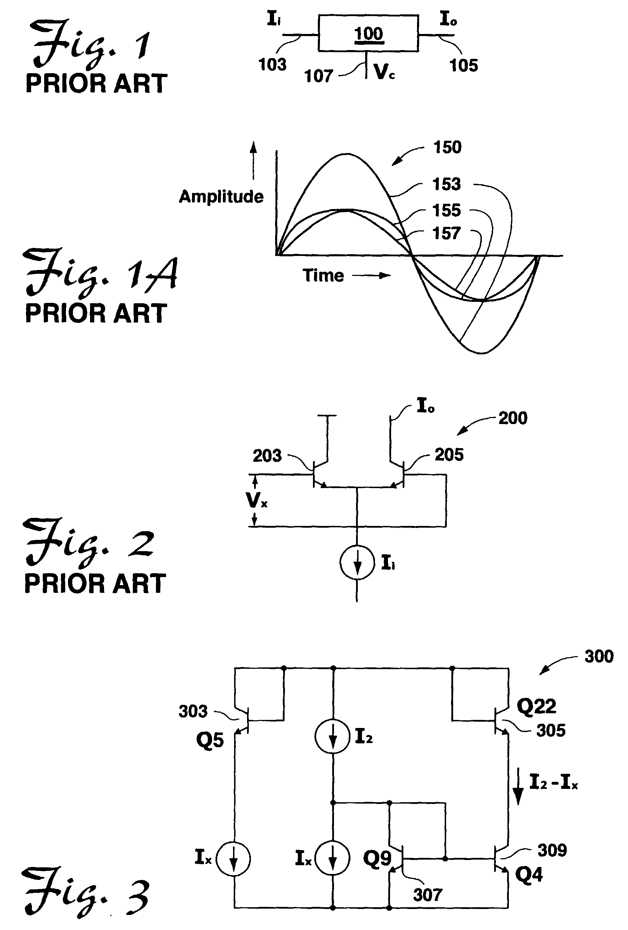

In applications which require the output to be dB-linear, as shown in Fig. 1:

$$20 \log(Io/Ii)=Ko + KiVc + .. \qquad (1)$$

where Io 105 is the output current, Ii 103 is the input current, Ko and Ki, etc. of equation (1), are constants in an arithmetic series which describes the logarithmic response on the left side of the equation and Vc 107 is a control voltage.

In the following discussion, the letter I will be used for input and output currents, and the letter V will denote control voltages.

Fig. 1A 150 shows a typical input current 153 of the type used in the prior art and in the invention as an input to an amplifier. Output current 155 illustrates the response of a typical compression amplifier of the prior art to the input current 153. Output current 157 illustrates the response of a dB-linear variable gain amplifier of the invention, showing how the dB-linear variable gain amplifier of the invention provides a linear response to the input at a dB-linear variable gain. It will be apparent that distortion products generated by the compression amplifier, which must be tolerated or removed by subsequent processing of the signal, are reduced or eliminated by the dB-linear variable gain amplifier.

In Fig. 2 200 we define the base to base voltage of Q7 203 and Q10 205 as Vx. Vt has a known value, as discussed in classical theory, of about 25.9 millivolts at 300°K (degrees Kelvin). It is sometimes called the "thermal" voltage. As Vx changes from positive and negative values with respect to Vt, or $-1<<Vx/Vt<<1$ for the equation

$$Io/Ii=1/(1+e^{Vx/Vt}) \qquad (2)$$

and Io goes from Ii to 0. This is a common method for implementing VGAs known as current sharing.

The purpose of a dB-linear VGA is to synthesize or approximate Vx to a function such that (2) can be expressed as (1). The approach used in this disclosure is an exact synthesis of the function rather than a piecewise linear approximation.

In Fig. 3 300 a predistortion block generates Vx, which is the diode current/voltage characteristic, and has a value of about 25.9 millivolts per decade of current change at a temperature of 300 °K over a wide range of currents. It is described by the equation below over about six decades of current change:

$$Vx/Vt=\ln((I2-Ix)/(Ix)) \qquad (3)$$

In Fig. 3 the emitter area of Q4 309 is equal to the emitter area of Q9 307, and the emitter area of Q5 303 is equal to the emitter area of Q22 305. This block allows a current I2-Ix to be developed as shown. This configuration will be modified to provide temperature stability and to define the desired final result; but Fig 3 conceptually describes the desired relationship for the currents involved.

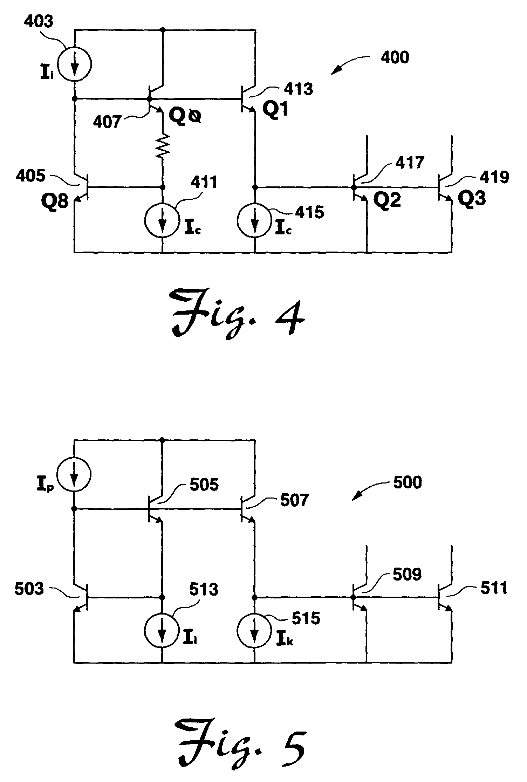

In Fig. 4 400, a resistor R5 409 has been added. Ii 403, an input current, is applied to the base of transistor 407 and to the collector of transistor 405, which are in a feed back configuration. A constant current, Ic 411, sets a bias point for the configuration. As current Ii 403 increases, Q8 405 requires more base current to conduct the increased collector current away from the base of Q0 407, so the voltage across R5 409 increases as Q0 407 provides extra base current to Q8 405. To maintain equilibrium, the base voltage of Q0 407 must also increase, and since the bases of Q0 and Q1 are connected, the base voltage of Q1 413 increases as well. With a constant current into Ic 415 the emitter voltage of Q1 413 must increase to keep a constant base to emitter voltage, required by the fixed current, and so the base voltage of Q2 417 and Q3 419 will also increase. The change is essentially linear, since it is controlled by the input current Ii 403 and resistance R5 409, so the current controlled by Q2 417 and Q3 419 will increase substantially exponentially. This is inherent in the physics of a semiconductor diode such as the base to emitter voltage of Q2 417 and Q3 419. Therefore:

$$Io/Ii=1/(1+(I2-Ix)/Ix)=Ix/2 \qquad (4)$$

If Ix is made equal to C0(e(C1Is)), where C0 and C1 are arbitrary constants, then (4) will have the desired form of (1). In this case,

$$Io/Ii=(I1/I2)(e(IcR5/Vt)) \qquad (5)$$

Substituting (5) in (4)

$$Io/Ii=(I1/I2)(e(IcR5/Vt))$$

or 20 log(I2/Ii)=20 log(I1/I2)+ 20 log(e(IcR5/Vt))

Since log N =0.4343 ln N

20 log(Io/Ii)=20 log(I1/I2) + 20(0.4343)(IcR5/Vt)  (6)

Equation 6 has the desired form. If we want the control variable to be an input voltage rather than a current, we need to do a V -> I conversion.

For a practical application (6) as described has a temperature dependence in Vt. I1, I2 are generated by the same function, so there is no temperature/process dependence in the Ko coefficient. To avoid temperature dependence in the K1 coefficient, we need to normalize Ic to have a PTAT (proportional to absolute temperature) characteristic.

Using the same translinear principle:

Ip=Ik(T/300), T in degrees Kelvin

Ic=(Ip/Ik)=Ii(T/300)

In Fig. 5 500, which is an embodiment of the invention demonstrating how, when an input current Ip is applied to the collector of transistor 503 and the bases of transistors 505 and 507, currents Ii 513 and Ik 515 may be adjusted to provide a temperature compensated voltage. The voltage so derived is applied to the bases of transistors 509 and 511, and log-linear output currents which are scalable to dB-linear currents are induced at the collectors of transistors 509 and 511.

As the ratio of Ii 513 and Ik 515 is varied, the temperature sensitive component of the output currents can be varied from negative through zero to positive values. This forms the basis for the proportional to absolute temperature (PTAT) current of the invention.

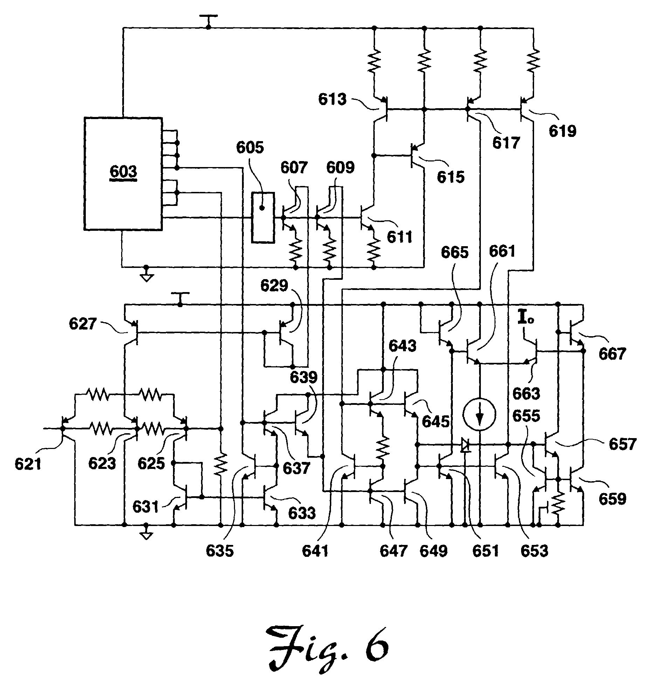

A V -> I (voltage to current) converter from Wiegerink, Seevinek, & Jager, "Offset Cancelling Circuit", JSSC, vol SC-24, pp651-658, June 1989 then provides a voltage input to the circuit, with the complete circuit shown in Fig. 6.

In Fig. 6 600, module 603 provides an input signal to transistors 635 and 637, a bias signal to transistor 629, and a bias for PTAT operation to module 605. The amplifier represented by transistors 621, 623, 625, 627, 629, 631, and 633 sets a first bias current for a PTAT characteristic in the circuit represented by transistors 635, 633, 637, and 639. The output from transistor 639 then sets a bias voltage for the bases of transistors 647 and 649 in the circuit comprising transistors 641, 643, 645, 647, 649, 651 and 653, which together form the circuit developing log-linear output currents. Module 605 supplies a base voltage which controls the response of transistors 607 and 609. Transistors 607 and 609 provide collector currents in response to the base voltage from module 605 which ratios the PTAT currents in the circuits discussed above.

Through transistor 611, module 605 also provides base voltages to transistors 613, 615, 617 and 619, which provide collector currents to apply an input signal to the base of transistor 643 and the collector of transistor 641. Transistor 619 also supplies a collector current to modify the response of transistor 653.

As described in earlier figures, dB-linear signals are generated at the collectors of transistors 651 and 653. The signal current from the collector of transistor 653 is then converted in polarity by transistors 655, 657, and 659, and the two log-linear signals discussed above are applied to transistor current clamps 665 and 667 and amplified by the pair of current sharing transistors 661 and 663. The desired signal Io then appears at the collector of 663. In this way, a dB-linear current is obtained from a linear input with substantially no temperature sensitivity.

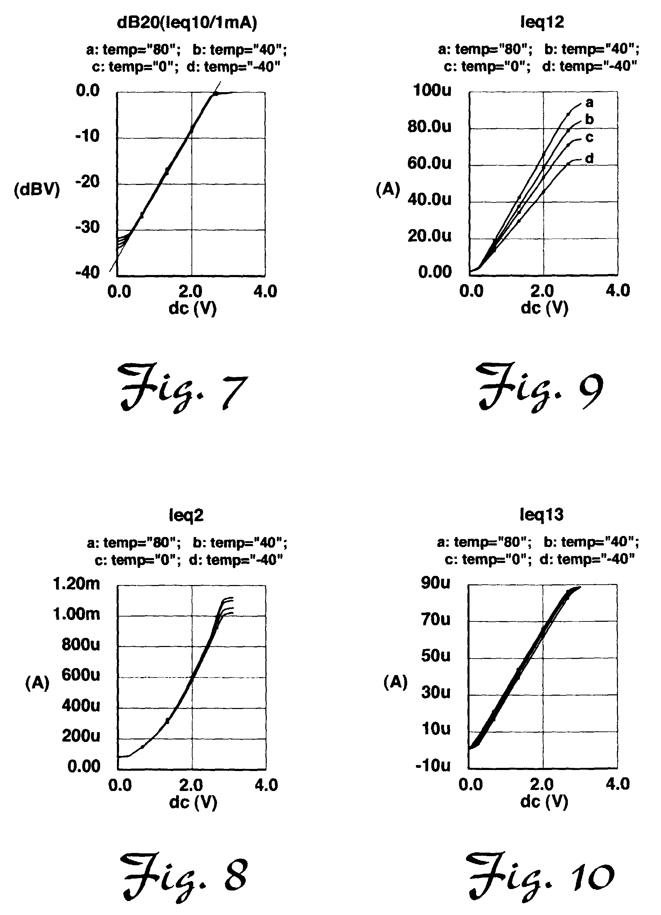

Fig. 7 demonstrates the dB-linear characteristics of the output as a function of temperature. It can be seen that a straight line relating linear voltage to the output current in dB is obtained.

Fig. 8 demonstrates the response of the output current to a linear voltage in terms of linear current. The linear voltage is related to the linear output current by an exponential line, showing again the dB-linear relationship.

Fig. 9 demonstrates the response of a linear circuit to a linear voltage over a temperature range without PTAT compensation.

Fig. 10 demonstrates the response of a linear circuit to a linear voltage over the same temperature range as in Fig. 9 with PTAT compensation, showing that the response is now stable as a function of temperature.

The foregoing descriptions of specific embodiments of the present invention have been presented for purposes of illustration and description. They are not intended to be exhaustive or to limit the invention to the precise forms disclosed, and it should be understood that many modifications and variations are possible in light of the above teaching. The embodiments were chosen and described in order to best explain the principles of the invention and its practical application, to thereby enable others skilled in the art to best utilize the invention and various embodiments with various modifications as are suited to the particular use contemplated. It is intended that the scope of the invention be defined by the Claims appended hereto and their equivalents.

## Claims

1. A dB-linear amplifier (Fig. 6) for producing a logarithmic variable gain response to a control input (603) comprising:

   means for developing a first signal (Vo,605) proportional to the control input;
   means for applying the first signal to an amplifier with a natural logarithmic variable gain response (Ie,665; Ie,667; Ic,661; Ic,663) at a bias current (Ie,661; Ie,663);
   means for scaling the gain response to a dB-linear (Ie,665; Ie,667) value; and
   means for providing an output current (Ic,663) proportional to the first signal.

2. The amplifier of claim 1 comprising:

   means for adjusting (643,645,647,649) the values of the bias current (Ie,661; Ie,663) and the output current (Ic,663) proportional to the first signal (Vo,605) to provide a temperature stable response.

3. The amplifier of claim 1 wherein the signal is a current (Ic,609; Ic,611).

4. The amplifier of claim 1 wherein the signal is a voltage (Vo,605).

5. A dB-linear amplifier for producing a logarithmic variable gain response (661,663,665,667) to a control input (603) comprising:

   means for providing a first signal (Vo,605);
   means for applying said first signal (Vo,605) to an amplifying means (661,663,665,667) with a natural logarithmic variable gain response;
   scaling means (Ie,665; Ie,667) for scaling the gain response to a dB-linear value; and
   means for providing an output current (Ic,663) responsive to a gain means which is proportional to the input current (Ic,635) at a gain proportional to the dB-linear value of the gain means.

6. The amplifier means of claim 5 comprising:

   adjusting means (643,645,647,649) for adjusting the value of the output current (Ic,663) proportional to the signal means (Vo,605) to provide a temperature stable response.

7. The amplifier means of claim 5 wherein the signal means (Ic,607; Ic,609; Ic,611) is in the form of a current.

8. The amplifier means of claim 5 wherein the signal means (Vo,605) is in the form of a voltage.

*Fig. 1*
**PRIOR ART**

$I_i$     **100**     $I_o$

103     107 $V_c$     105

*Fig. 1A*
**PRIOR ART**

Amplitude

150
153
155
157

Time ⟶

*Fig. 2*
**PRIOR ART**

$I_o$ ⟶ 200

203     205

$V_x$

$I_i$

*Fig. 3*

300

303     **Q22**

**Q5**     $I_2$     305

$I_2 - I_x$

$I_x$     $I_x$     **Q9**     309

**Q4**

307

*Fig. 4*

*Fig. 5*

*Fig. 6*

**dB20(leq10/1mA)**

a: temp="80"; b: temp="40";
c: temp="0"; d: temp="-40"

*Fig. 7*

**leq2**

a: temp="80"; b: temp="40";
c: temp="0"; d: temp="-40"

*Fig. 8*

**leq12**

a: temp="80"; b: temp="40";
c: temp="0"; d: temp="-40"

*Fig. 9*

**leq13**

a: temp="80"; b: temp="40";
c: temp="0"; d: temp="-40"

*Fig. 10*